# EUROPEAN PATENT APPLICATION

(11) **EP 2 479 410 A1**
(43) Date of publication of application: **25.07.2012**
(21) Application number: 10817167.9
(22) Date of filing: 14.09.2010
(51) Int. Cl.: F02D 45/00, H01L 25/065, H01L 25/07, H01L 25/18

(54) **ELECTRONIC CONTROL DEVICE FOR VEHICLE**

(30) Priority: 18.09.2009 JP 2009216384
(71) Applicant: Keihin Corporation, Tokyo 163-0539 (JP)
(72) Inventor: ASOU, Ryuji, Shioya-gun Tochigi 329-1233 (JP); SUGAWARA, Hiaki, Shioya-gun Tochigi 329-1233 (JP)
(74) Representative: Hertz, Oliver
(86) International application number: PCT/JP2010/065826
(87) International publication number: WO 2011/034054

(57) **Abstract**

In a vehicle electronic control unit (41), a semiconductor device (52) is mounted on a printed circuit board (51). In the semiconductor device (52), a custom chip (57) and a microcomputer chip (58) are arranged in a package (54), (55) in a stacked manner. On the custom chip (57), a first input circuit and a first output circuit for inputting and outputting signals or the like to and from the microcomputer chip (58) are formed. On the printed circuit board (51), a second input circuit and a second output circuit for inputting and outputting signals or the like to and from the microcomputer chip (58) while bypassing the custom chip (57) are formed.

## Description

### TECHNICAL FIELD

The present invention relates to a vehicle electronic control unit.

### BACKGROUND ART

A vehicle electronic control unit that controls an internal combustion engine is provided in a vehicle. The vehicle electronic control unit is configured to receive signals of sensors or the like to control the amount of fuel supplied to the internal combustion engine and to ignite the fuel for controlling the internal combustion engine.

A conventional vehicle electronic control unit is configured to include a CPU (Central Processing Unit) serving as a calculation device, an input circuit with signals from an external device such as a storage device or a sensor input thereto, an output circuit for outputting signals obtained by calculations by the CPU to the external device, a communication circuit that performs a communication process, a relay driving circuit that operates a relay, a driving circuit that energizes an electric actuator such as a motor, a current detection circuit that detects an energized state of the electric actuator, and a power supply circuit that adjusts a voltage from a battery. The CPU, a memory, and the respective circuits are individually mounted on a printed board.

### PRIOR ART DOCUMENT

### PATENT DOCUMENT

Patent Document 1: Japanese Patent Application Laid-open No. 2009-85142

### SUMMARY OF THE INVENTION

### PROBLEM TO BE SOLVED BY THE INVENTION

Various controls are required for recent vehicle electronic control units and thus a large number of circuits are needed and the vehicle electronic control unit becomes larger. However, when the vehicle electronic control unit is incorporated in a motorcycle, downsizing of the unit has been desired because of space limitations.
The present invention has been achieved in view of the above problems, and an object of the present invention is to downsize a vehicle electronic control unit.

### MEANS FOR SOLVING THE PROBLEM

An aspect of the present invention provides a vehicle electronic control unit including a circuit board that can be electrically connected to an external device and a controlling target, and a semiconductor device mounted on the circuit board, wherein the semiconductor device includes a first chip that is provided with a circuit that processes a signal input from the external device and a signal output to the controlling target, a second chip that is accommodated in a same package so as to be superimposed on the first chip and that includes a calculation device and a storage device, a first external terminal electrically connected only to the first chip, and a second external terminal electrically connected only to the second chip.

Another aspect of the present invention provides the vehicle electronic control unit according to claim 1, wherein a first input circuit and a first output circuit commonly used for a plurality of vehicle types are integrated in the first chip, and the circuit board is provided with a second input circuit and a second output circuit whose design can be changed according to a vehicle type.

Still another aspect of the present invention provides the vehicle electronic control unit according to claim 2, wherein, as the second input circuit, a waveform shaping circuit that converts an output signal of a crank angle sensor that detects rotation of a crankshaft of an engine into a digital signal is provided.

Still another aspect of the present invention provides the vehicle electronic control unit according to claim 2 or 3, wherein, as the second output circuit, a driving circuit that outputs a drive signal of a fuel pump that supplies fuel to an engine is provided.

Still another aspect of the present invention provides the vehicle electronic control unit according to claim 1, wherein the first chip includes a power supply circuit that adjusts a voltage supplied to the semiconductor device and supplies power to the first chip and the second chip.

Still another aspect of the present invention provides the vehicle electronic control unit according to claim 5, wherein the power supply circuit includes a voltage monitoring circuit that outputs a signal that resets processes of the first chip and the second chip when a voltage supplied to the first chip and the second chip becomes lower than a threshold set in advance.

Still another aspect of the present invention provides the vehicle electronic control unit according to claim 1, wherein the first chip includes a communication circuit that can transmit and receive data to and from at least one of the external device and the controlling target.

Still another aspect of the present invention provides the vehicle electronic control unit according to claim 1, wherein the first chip includes an analog input circuit that converts an analog signal output from the external device into a digital signal and outputs a converted signal to the second chip, and the analog input circuit includes a protection circuit that protects an analog signal from noise generated in an output circuit.

Still another aspect of the present invention provides the vehicle electronic control unit according to claim 1, wherein the first chip includes a pulse circuit that converts a pulse signal output from the external device into a digital pulse signal and outputs a converted signal to the second chip.

Still another aspect of the present invention provides the vehicle electronic control unit according to claim 1, wherein the first chip includes a switch input circuit that converts a voltage value that varies depending on an on/off operation of an external device into a digital signal and outputs a converted signal to the second chip.

Still another aspect of the present invention provides the vehicle electronic control unit according to claim 1, wherein the first chip includes a process monitoring circuit that monitors an operation of the second chip and resets a process of the calculation device of the second chip when the operation is determined to have an abnormality.

Still another aspect of the present invention provides the vehicle electronic control unit according to claim 11, wherein the process monitoring circuit is a watchdog timer.

Still another aspect of the present invention provides the vehicle electronic control unit according to claim 1, wherein the first chip includes a switch driving circuit that switches an energized state of the controlling target.

Still another aspect of the present invention provides the vehicle electronic control unit according to claim 1, wherein the first chip includes a return circuit that switches off energization to the controlling target when a value of a current energized to the controlling target exceeds a value set in advance.

Still another aspect of the present invention provides the vehicle electronic control unit according to claim 1, wherein the circuit board includes a circuit that inputs a signal from the external device to the second chip while bypassing the first chip.

Still another aspect of the present invention provides the vehicle electronic control unit according to claim 1, wherein the circuit board includes a driving circuit that outputs a signal for driving the controlling target from the second chip while bypassing the first chip.

Still another aspect of the present invention provides the vehicle electronic control unit according to claim 1, wherein the semiconductor device includes a first custom chip having an input circuit to which a signal from the external device is input formed therein and a second custom chip having an output circuit that outputs a signal to the controlling target formed therein, and the second chip is stacked on the first and second custom chips.

### EFFECT OF THE INVENTION

According to the present invention, at least a part of an input circuit and an output circuit is integrated in a custom chip, so that a circuit can be downsized. Furthermore, by using a semiconductor device in which a custom chip and a microcomputer chip are accommodated in a package, a vehicle electronic control unit can be downsized.

### BRIEF DESCRIPTION OF THE DRAWINGS

[FIG. 1] FIG. 1 shows a configuration of a vehicle electronic control unit and an engine according to the present invention.
[FIG. 2] FIG. 2 is a sectional view of relevant parts of the vehicle electronic control unit.
[FIG. 3] FIG. 3 is a block diagram of the vehicle electronic control unit.
[FIG. 4] FIG 4 is a sectional view showing a modification of the vehicle electronic control unit.

### EMBODIMENT FOR CARRYING OUT THE INVENTION

An embodiment of the present invention will be explained below in detail.

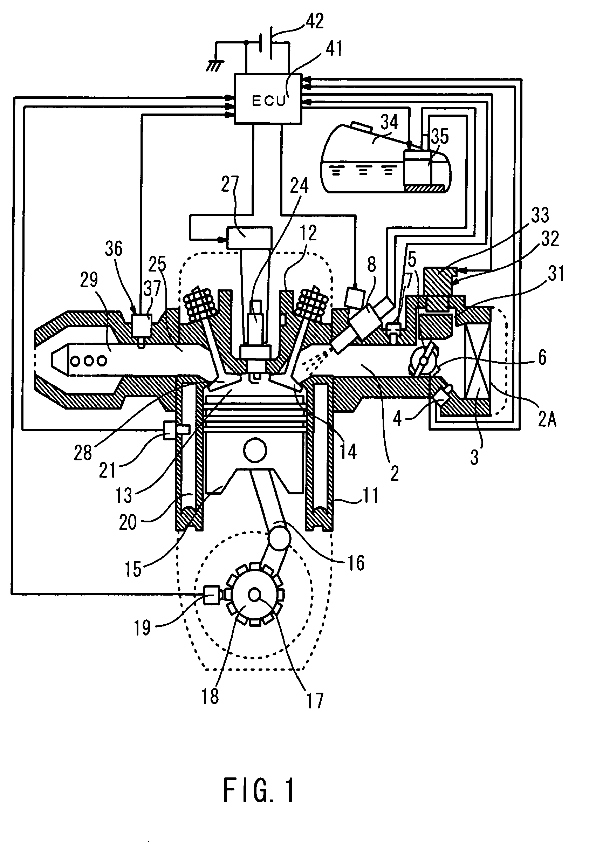

FIG. 1 is a schematic configuration diagram of a system including an internal combustion engine and its control unit.
An engine 1 serving as the internal combustion engine includes an intake pipe 2 that draws air. In the intake pipe 2, an air cleaner 3 is attached to an upstream-side intake port 2A. After an intake temperature sensor 4 is provided, a flow-path area can be adjusted by a throttle valve 5. The position (opening degree) of the throttle valve 5 is monitored by a throttle position sensor 6. The intake pipe 2 is also provided with a path 31 that bypasses the throttle valve 5. The bypass path 31 is provided with an ISC (Idol Speed Control) valve 32. The ISC valve 32 is configured to drive a stepping motor 33 for adjusting the flow-path area of the bypass path 31, and can adjust an engine speed at the time of starting the engine 1 or idle running.

Furthermore, an intake pressure sensor 7 and an injector 8 for fuel injection are provided in this order at a downstream of the throttle valve 5. The intake pipe 2 is then connected to a combustion chamber 13 formed of a cylinder head 12 and a cylinder block 11. The injector 8 is connected to a fuel tank 34. The fuel tank 34 is provided with a fuel pump 35, so that a fuel in the tank can be supplied to the injector 8. Further, an intake valve 14 is inserted into a boundary part of the intake pipe 2 and the combustion chamber 13 so as to be able to open and close a piping path.

A piston 15 is slidably inserted into the cylinder block 11. The piston 15 is coupled via a crank arm 16 to a crankshaft 17, so that a linear reciprocating motion of the piston 15 is converted into a rotating motion of the crankshaft 17 serving as an output shaft. The crankshaft 17 is rotatably supported by the cylinder block 11 and a timing rotor 18 for detecting its number of rotations is fixed thereto. A crank angle sensor 19 is arranged in the vicinity of the timing rotor 18. Further, in the cylinder block 11, a flow path 20 for circulating cooling water is formed and an engine temperature sensor 21 for measuring the temperature of the engine 1 is also attached.

In addition to the intake pipe 2, an ignition plug 24 and an exhaust pipe 25 are attached to the cylinder head 12. The ignition plug 24 is electrically connected to an ignition coil 27 so that a high voltage is applied thereto. An exhaust valve 28 is attached to an opening of the exhaust pipe 25 connected to the combustion chamber 13 so as to be able to open and close. Furthermore, an oxygen sensor 36 is provided in the middle of the exhaust pipe 25. The oxygen sensor 36 measures the oxygen concentration in exhaust air and its temperature is controlled by an oxygen sensor heater 37. A catalyst converter 29 is further provided on the downstream side of the oxygen sensor 36.

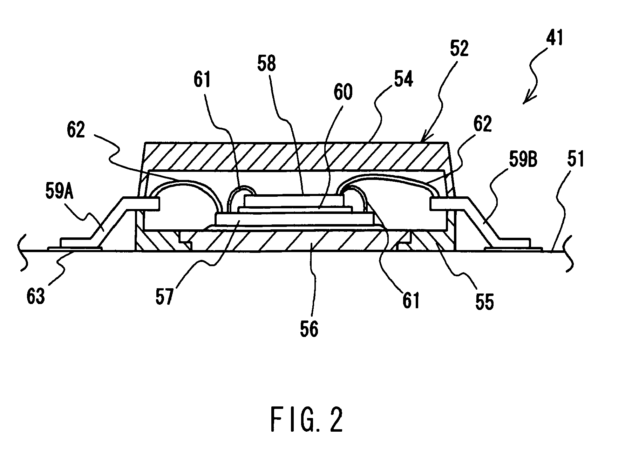

Next, a configuration of a vehicle electronic control unit 41 that controls the engine 1 is explained with reference to FIG. 2. The vehicle electronic control unit 41 may be also referred to as "ECU".

As FIG. 2 shows its schematic configuration, the vehicle electronic control unit 41 includes a printed circuit board 51, circuits and signal input/output terminals are formed on the printed circuit board 51, and a semiconductor device 52 is mounted thereon.
According to the semiconductor device 52, a radiation heat sink 56 is provided within a top package 54 and a bottom package 55 and two chips 57 and 58 are arranged in a stacked manner. A large number of leads 59A and 59B (external terminals) are drawn to outside the packages 54 and 55. By using these leads 59A and 59B, signals are transmitted and received to and from external circuits and devices and power is supplied from a battery 42.

The heat sink 56 is fixed to the bottom package 55 and is made of a material having a higher heat conductivity than other members. The custom chip 57 serving as a first semiconductor chip is fixed on a top surface of the heat sink 56 by an adhesive so that heat can be conducted. Various circuits to be explained later are formed in the custom chip 57. The area of the heat sink 56 as viewed from a plane is larger than that of the custom chip 57, so that the heat sink 56 has a sufficient contact area with the custom chip 57.

Furthermore, the microcomputer chip 58 serving as a second semiconductor chip is arranged on the custom chip 57. The microcomputer chip 58 is fixed via a resin sheet 60 to the custom chip 57 by an adhesive. The microcomputer chip 58 is configured to include a calculation device and a storage device and to perform various processes to be explained later.
The microcomputer chip 58 is formed to be smaller than the custom chip 57 and electrodes (not shown) are formed on a top surface of the microcomputer chip 58 and a top surface of an outer circumferential part of the custom chip 57. By electrically connecting these electrodes to each other by conductive wires 61 such as gold, transmission and reception of signals between the chips 57 and 58 and power supply are performed.

An end of the conductive wire 62 is electrically connected to the custom chip 57 or the microcomputer chip 58. The other end of the wire 62 is electrically connected to the leads 59A and 59B by a wire bonding technique. An end of the leads 59A and 59B is arranged within the packages 54 and 55 and bent so as to be substantially in parallel with the chips 57 and 58. The other end of the leads 59A and 59B is arranged outside the packages 54 and 55 and electrically connected to an electrode 63 formed on the printed circuit board 51 by solder.

According to the present embodiment, at a part that the lead 59A serving as a first external terminal is connected to the custom chip 57, signals are transmitted and received and power is supplied between an external device (including a circuit of the printed circuit board 51) and the custom chip 57. At a part that the lead 59B serving as a second external terminal is directly connected to the microcomputer chip 58, signals are transmitted and received between the external device and the microcomputer chip 58. That is, in this semiconductor device 52, a part of signals is input from the external device to the microcomputer chip 58 while bypassing the custom chip 57. A part of signals is output from the microcomputer chip 58 to the external device while bypassing the custom chip 57.

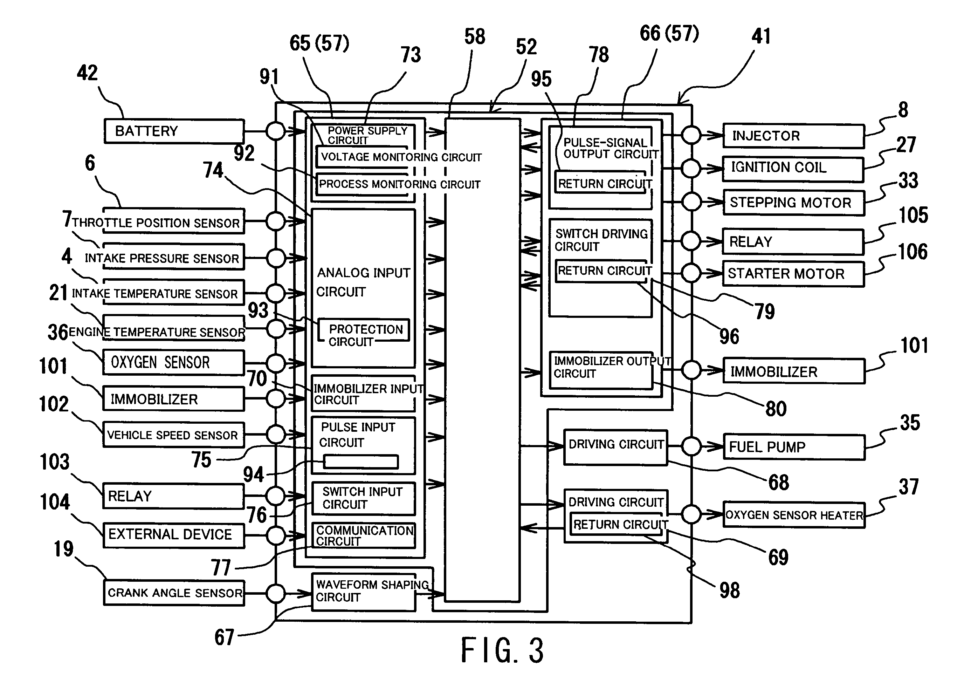

Next, FIG. 3 is a block diagram of the vehicle electronic control unit.
The vehicle electronic control unit 41 includes an input circuit 65 (first input circuit) and a waveform shaping circuit 67 (second input circuit) on a signal input side. The vehicle electronic control unit 41 includes an output circuit 66 (first output circuit) and driving circuits 68 and 69 (second output circuit) on a signal output side.
The input circuit 65 and the output circuit 66 are formed in the custom chip 57. The input circuit 65 and the output circuit 66 mainly include circuits for realizing functions commonly used in a plurality of vehicle types. By forming these circuits 65 and 66 in the custom chip 57, the vehicle electronic control unit 41 can be downsized.
Furthermore, the waveform shaping circuit 67 and the driving circuits 68 and 69 are formed on the printed circuit board 51 and mainly include circuits needed to be designed for each vehicle type or whose design can be changed for each vehicle type. The waveform shaping circuit 67 and the driving circuits 68 and 69 on the printed circuit board 51 are directly connected to the microcomputer chip 58 via the lead 59B and the wire 61 while bypassing the custom chip 57.

The first and second input circuits are explained below.
First, the input circuit 65 formed in the custom chip 57 serving as the first input circuit includes a power supply circuit 73, an analog input circuit 74, an immobilizer input circuit 70, a pulse input circuit 75, a switch input circuit 76, and a communication circuit 77. These circuits 73 to 77 are connected to the microcomputer chip 58 so that signals can be input and output and power can be supplied.

The power supply circuit 73 is connected to the battery 42 and configured to adjust a battery voltage to a voltage at which the respective circuits of the vehicle electronic control unit 41 can be driven. Further, the power supply circuit 73 includes a voltage monitoring circuit 91 for monitoring a voltage supplied to the respective circuits and a process monitoring circuit 92 that monitors an operation in the microcomputer chip 58 and an operation of the microcomputer chip 58.

When the voltage monitoring circuit 91 detects that a supply voltage is lower than a threshold set in advance, the circuit 91 outputs a reset signal to logic circuits of the input circuit 65 and the output circuit 66 and the microcomputer chip 58 to prevent erroneous operations when a voltage is decreased.
The process monitoring circuit 92 is configured to monitor the operation in the microcomputer chip 58 so as to determine whether an operation abnormality has occurred in a circuit of the microcomputer chip 58.

An example of the process monitoring circuit 92 includes a watchdog timer. The watchdog timer includes a timer circuit that counts a time during which the microcomputer chip 58 performs a predetermined process and resets a counted value when the process ends before the counted value of the timer circuit reaches a value set in advance. Meanwhile, when the process of the microcomputer chip 58 does not end even when the value set in advance is exceeded, it is determined that an abnormality has occurred in the circuit of the microcomputer chip 58 and outputs the reset signal to the respective logic circuits of the microcomputer chip 58 and the custom chip 57. By providing the process monitoring circuit 92 in the custom chip 57, the number of components can be reduced and the vehicle electronic control unit 41 can be downsized.

The analog input circuit 74 is configured to cause an analog signal from the external device including various sensors to be input thereto and to output a digital signal to the microcomputer chip 58 after a predetermined process is performed. The analog input circuit 74 thus includes an A/D (Analog/digital) conversion circuit. Further, the analog input circuit 74 is provided with a protection circuit 93 that protects circuits from electrostatic discharge noise superimposed on an analog signal. By providing the protection circuit 93, even when noise, for example, ignition noise is generated in the output circuit 66 formed in the same chip, it is possible to prevent the noise from affecting an analog signal of the input circuit 65.

Examples of the external device including sensors connected to the analog input circuit 74 include the throttle position sensor 6, the intake pressure sensor 7, the intake temperature sensor 4, the engine temperature sensor 21, and the oxygen sensor 36. The external device can be a device installed outside the vehicle electronic control unit 41 or can be a circuit or a device formed on the printed circuit board 51 other than the semiconductor device 52.

An immobilizer 101 is connected to the immobilizer input circuit 70 and an ID code output from the immobilizer 101 is input to the immobilizer input circuit 70. The immobilizer input circuit 70 converts an analog ID code into a digital signal and outputs the converted signal to the microcomputer chip 58.

The pulse input circuit 75 is configured to cause an analog pulse signal from the external device including various sensors to be input thereto and to output a digital pulse signal to the microcomputer chip 58 after a predetermined process is performed. An example of the external device connected to the pulse input circuit 75 includes a vehicle speed sensor 102. By providing a circuit that converts an analog pulse signal into a digital signal in the custom chip 57, the vehicle electronic control unit 41 can be downsized. When a digital filter circuit 94 is added to the pulse input circuit 75, resistance to external noise can be improved and a more accurate digital signal can be input to the microcomputer chip 58.

The switch input circuit 76 is configured to cause an analog voltage value that changes according to an operation of an external switch to be input thereto and to output a digital signal that indicates an on/off state of the external switch to the microcomputer chip 58. An example of the external switch connected to the switch input circuit 76 includes a relay provided in the battery 42.

The communication circuit 77 is configured to control data transmission and data reception between the external device and the microcomputer chip 58. K-Line is an example as a protocol used for communications. Other examples of the communication protocol include a CAN (Controller Area Network) and an SPI (Serial Peripheral Interface). An example of an external device 104 includes an acceleration sensor for an SRS (Supplemental Restraint System). According to the vehicle electronic control unit 41, communications are carried out between the microcomputer chip 58 and the external device so that data transmission and data reception are possible. Accordingly, even when data is transmitted to drivers for a large number of external devices and when a plurality of commands are transmitted, the number of lines can be reduced.

The waveform shaping circuit 67 formed on the printed circuit board 51 serving as the second input circuit is configured to cause a waveform signal output from the crank angle sensor 19 to be input thereto and to output a pulse signal to the microcomputer chip 58. Because the waveform signal output from the crank angle sensor 19 is different depending on the vehicle type, the waveform shaping circuit 67 needs to be formed so that an appropriate pulse signal can be obtained for each vehicle type. Accordingly, the waveform shaping circuit 67 is formed on the printed circuit board 51 without integrated in the custom chip 57.

The first and second output circuits are explained below.
The output circuit 66 formed in the custom chip 57 serving as the first output circuit includes a pulse-signal output circuit 78, a switch driving circuit 79, and an immobilizer output circuit 80. These circuits 78 to 80 are connected so that signals can be input to the microcomputer chip 58.

The pulse-signal output circuit 78 is configured to receive a digital signal output from the microcomputer chip 58 to form an analog signal that drives a controlling target (an external device) and to output the received signal. The switch driving circuit is thus provided with an A/D conversion circuit that converts a digital signal into an analog signal. The pulse-signal output circuit 78 is further provided with a return circuit 95 that detects an energized state of the controlling target, according to need. The return circuit 95 monitors the value of a current supplied to the controlling target and, when a current exceeds a value set in advance, stops a process of the pulse-signal output circuit 78 to switch off energization to the controlling target. By providing the return circuit 95, the custom chip 57 and the controlling target can be protected. Examples of the controlling target include the injector 8, the ignition coil 27, and the stepping motor 33 of the ISC valve 32.

The switch driving circuit 79 is configured to receive a digital signal output from the microcomputer chip 58 to form an on/off signal that switches the energized state of the controlling target and to output the received signal to the corresponding controlling target. Occasionally, the controlling target is the same device as the external device. The switch driving circuit 79 is further provided with a return circuit 96. When an overcurrent flows, the return circuit 96 stops an operation of the switch driving circuit 79 and protects the custom chip 57 and the controlling target. Examples of the controlling target include a relay 105 and a starter motor 106.

Because the switch driving circuit 79 generates heat depending on the type of the controlling target, countermeasures against radiation are needed. Conventionally, a switch driving circuit is provided on a printed circuit board in a scattered manner and a solid pattern made of a conductive material is provided for each circuit for radiation. For example, when an FET (Field Effect Transistor) is used as the switch driving circuit, heat generated by the FET is radiated from the solid pattern on the printed circuit board. When a plurality of FETs are incorporated, such a configuration has to be designed for each of the FETs. However, in the vehicle electronic control unit 41, because the switch driving circuit 79 is integrated in the custom chip 57, an area that generates heat concentrates on the chip. Accordingly, by controlling radiation of the custom chip 57, countermeasures against radiation can be taken. That is, by causing the heat sink 56 shown in FIG. 2 to perform radiation, countermeasures against radiation do not need to be taken for each switch driving circuit unlike conventional cases. Consequently, as compared to a case of forming a solid pattern for each switch driving circuit, the area of the printed circuit board 51 can be reduced.

The immobilizer output circuit 80 is configured to receive a digital signal output from the microcomputer chip 58 to form an analog pulse signal and to output the received signal to the immobilizer 101. An example of the signal output to the immobilizer 101 includes a signal that indicates a result of matching between an ID code obtained from a key and an ID code of a vehicle main body.

The driving circuits 68 and 69 formed on the printed circuit board 51 serving as the second output circuit are configured to receive a digital signal from the microcomputer chip 58 and to output a signal that drives a device serving as the controlling target. Examples of the controlling target include the fuel pump 35 and the oxygen sensor heater 37. The oxygen sensor heater 37 is provided for accurately controlling an operation temperature that causes large influences on the characteristics of the oxygen sensor 36. The driving circuit 69 is provided with a return circuit 98 that confirms that the controlling target is normally operated. The return circuit 98 monitors the value of a current supplied to the controlling target, stops a process of the driving circuit 69, and protects the driving circuit 69 and the controlling target.

Because a capacity and a resistance value of a heater are different depending on the vehicle type in the fuel pump 35 and the oxygen sensor heater 37, the driving circuits 68 and 69 and the return circuit 98 need to be formed so that an appropriate signal can be output for each vehicle type. Accordingly, the driving circuits 68 and 69 are formed on the printed circuit board 51 without integrated in the custom chip 57.

An operation of the vehicle electronic control unit 41 is explained next.
To start a vehicle, power from the battery 42 is supplied from the printed circuit board 51 via the lead 59A to the power supply circuit 73 of the input circuit 65 in the custom chip 57. The power supply circuit 73 adjusts a battery voltage to a voltage appropriate for operations of the custom chip 57 and the microcomputer chip 58, such as 5 V, and supplies it to the respective circuits. Information of an ID code of a key inserted into a key cylinder of the vehicle is input from the immobilizer 101 to the immobilizer input circuit 80 and passed to the microcomputer chip 58. The microcomputer chip 58 compares the ID code of the key to an ID code stored in a storage device in advance and, when they coincide with each other, outputs a permission signal that permits driving of the immobilizer output circuit 80 of the output circuit 66 in the custom chip 57. A permission signal is output from the immobilizer output circuit 80 to the immobilizer 101, so that the engine 1 can start. When the ID codes do not coincide with each other, a signal that does not permit the engine 1 to start is output from the immobilizer output circuit 80 to the immobilizer 101.

While the engine 1 runs, outputs of the throttle position sensor 6, the intake pressure sensor 7, the intake temperature sensor 4, the engine temperature sensor 21, and the oxygen sensor 36 are input to the analog input circuit 74 in the custom chip 57 as needed. The analog input circuit 74 converts these analog signals into digital signals, further processes the converted signals according to need, and then passes these signals to the microcomputer chip 58. A signal from the vehicle speed sensor 102 is input to the pulse input circuit 75 and a digital signal that indicates information of a vehicle speed formed in the pulse input circuit 75 are input to the microcomputer chip 58. The microcomputer chip 58 decides a fuel injection amount and an ignition timing by a throttle position, an intake pressure, an intake temperature, an engine temperature, and a vehicle speed, and decides an adjustment amount of the fuel injection amount by the oxygen concentration in exhaust gas.

According to the rotation of the crankshaft 17, an output of the crank angle sensor 19 is input to the waveform shaping circuit 67 on the printed circuit board 51. A waveform signal shaped by the waveform shaping circuit 67 passes through the lead 59B and the wire 62 to be directly input to the microcomputer chip 58. The microcomputer chip 58 identifies the engine speed and a stroke of the engine 1 by the waveform signal to decide the timing of igniting fuel.

Next, according to the stroke of the engine 1, drive signals of the injector 8 and the ignition coil 27 are output from the microcomputer chip 58. These signals pass through the pulse-signal output circuit 78, the lead 59A, and the printed circuit board 51 to be output to the injector 8 and the ignition coil 27. An appropriate amount of fuel is injected from the injector 8 to the intake pipe 2, mixed with air, and then the fuel is supplied to the combustion chamber 13. By switching energization to the ignition coil 27, the ignition plug 24 is operated to ignite the fuel in the combustion chamber 13. As a result, the piston 15 descends to generate power. According to need, a drive signal of the stepping motor 33 of the ISC valve 31 is output from the pulse-signal output circuit 78 to change the amount of air in the intake pipe 2 for controlling the engine speed at the time of idling.

Furthermore, the microcomputer chip 58 outputs a signal for driving the fuel pump 35 as needed. This signal is directly output from the driving circuit 68 to the fuel pump 35 by the lead 59B while bypassing the custom chip 57. The fuel pump 35 is thus operated and fuel is supplied through the injector 8 to the intake pipe 2.

In this way, by using the semiconductor device 52 that accommodates the custom chip 57 and the microcomputer chip 58 in a package, the vehicle electronic control unit 41 can be downsized. While the respective logic circuits are conventionally formed on a printed circuit board, predetermined logic circuits are gathered in a same package in the present embodiment, so that lines and components on the printed circuit board 51 are reduced. Consequently, the area of the printed circuit board 51 can be reduced and the vehicle electronic control unit 41 can be downsized.

Circuits that can be commonly used for a plurality of vehicle types are integrated in the custom chip 57 and circuits that need to be designed for each vehicle type are formed on the printed circuit board 51 so that inputs are directly made to the microcomputer chip 48. The semiconductor device 52 can thus have general-purpose properties. Because common circuits are in a package, design changes can be rapidly treated. Conventionally, circuits and lines are laid out on the printed circuit board 51 for each vehicle type and thus countermeasures against noise and radiation have had to be considered for each time. However, because circuits commonly used for a plurality of vehicle types are integrated in the custom chip 57, when the vehicle electronic control unit 41 is newly developed, it suffices that only a peripheral circuit (a configuration of a circuit connecting an integrated circuit to an external device) is designed. The number of developing steps can thus be reduced.

Furthermore, the power supply circuit 73 is integrated in the custom chip 57 and the custom chip 57 and the microcomputer chip 58 are arranged in a stacked manner. Accordingly, as compared to conventional cases, the length of a line from the power supply circuit 73 to the microcomputer chip 58 can be reduced. Consequently, the respective circuits are hardly influenced by external noise and power can be stably supplied to these circuits.

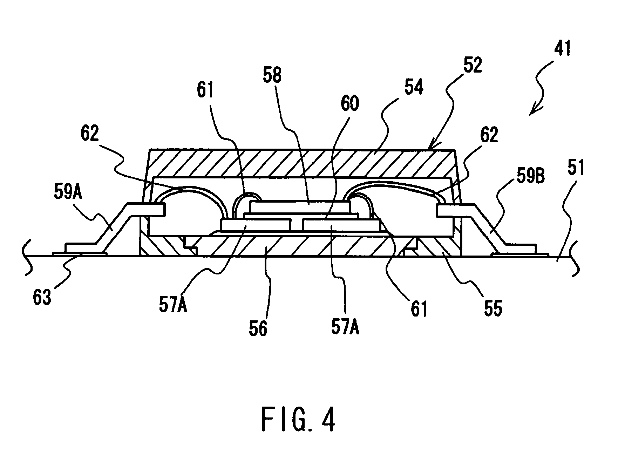

FIG 4 shows a modification of the present embodiment.
A vehicle electronic control unit 111 has a configuration in which a semiconductor device 112 is mounted on the printed circuit board 51. The semiconductor device 112 includes a first custom chip 57A in which the input circuit 65 is integrated and a second custom chip 57B in which the output circuit 66 is integrated, and has a stacked configuration in which the microcomputer chip 58 is stacked on these custom chips 57A and 57B. Only the input circuit 65 is formed in the first custom chip 57A and the output circuit 66 is not formed therein. Similarly, only the output circuit 66 is formed in the second custom chip 57B and the input circuit 65 is not formed therein. Because the input circuit 65 and the output circuit 66 are provided in different chips, it is possible to prevent noise of the output circuit 66 from influencing on the input circuit 65 and vice versa.

Note that the present invention is construed as not being limited to the examples and conditions mentioned in the above embodiment. In the present invention, various changes and modifications of the embodiment can be made without departing from the spirit and scope thereof.
For example, a custom chip can be divided into three or more. Furthermore, when two or more custom chips are provided, circuits formed in a custom chip are not limited to the example explained above. For example, it suffices to provide a custom chip only including the power supply circuit 73, a custom chip including at least a part of the input circuit 65 and a part of the output circuit 66, or a custom chip including at least a part of the output circuit 66 and a part of the input circuit 65.

## Claims

1. A vehicle electronic control unit comprising:
a circuit board that can be electrically connected to an external device and a controlling target; and
a semiconductor device mounted on the circuit board, wherein
the semiconductor device includes:
a first chip that is provided with a circuit that processes a signal input from the external device and a signal output to the controlling target;
a second chip that is accommodated in a same package so as to be superimposed on the first chip and that includes a calculation device and a storage device;
a first external terminal electrically connected only to the first chip; and
a second external terminal electrically connected only to the second chip.

2. The vehicle electronic control unit according to claim 1, wherein
a first input circuit and a first output circuit commonly used for a plurality of vehicle types are integrated in the first chip, and
the circuit board is provided with a second input circuit and a second output circuit whose design can be changed according to a vehicle type.

3. The vehicle electronic control unit according to claim 2, wherein, as the second input circuit, a waveform shaping circuit that converts an output signal of a crank angle sensor that detects rotation of a crankshaft of an engine into a digital signal is provided.

4. The vehicle electronic control unit according to claim 2 or 3, wherein, as the second output circuit, a driving circuit that outputs a drive signal of a fuel pump that supplies fuel to an engine is provided.

5. The vehicle electronic control unit according to claim 1, wherein the first chip includes a power supply circuit that adjusts a voltage supplied to the semiconductor device and supplies power to the first chip and the second chip.

6. The vehicle electronic control unit according to claim 5, wherein the power supply circuit includes a voltage monitoring circuit that outputs a signal that resets processes of the first chip and the second chip when a voltage supplied to the first chip and the second chip becomes lower than a threshold set in advance.

7. The vehicle electronic control unit according to claim 1, wherein the first chip includes a communication circuit that can transmit and receive data to and from at least one of the external device and the controlling target.

8. The vehicle electronic control unit according to claim 1, wherein the first chip includes an analog input circuit that converts an analog signal output from the external device into a digital signal and outputs a converted signal to the second chip, and the analog input circuit includes a protection circuit that protects an analog signal from noise generated in an output circuit.

9. The vehicle electronic control unit according to claim 1, wherein the first chip includes a pulse circuit that converts a pulse signal output from the external device into a digital pulse signal and outputs a converted signal to the second chip.

10. The vehicle electronic control unit according to claim 1, wherein the first chip includes a switch input circuit that converts a voltage value that varies depending on an on/off operation of an external device into a digital signal and outputs a converted signal to the second chip.

11. The vehicle electronic control unit according to claim 1, wherein the first chip includes a process monitoring circuit that monitors an operation of the second chip and resets a process of the calculation device of the second chip when the operation is determined to have an abnormality.

12. The vehicle electronic control unit according to claim 11, wherein the process monitoring circuit is a watchdog timer.

13. The vehicle electronic control unit according to claim 1, wherein the first chip includes a switch driving circuit that switches an energized state of the controlling target.

14. The vehicle electronic control unit according to claim 1, wherein the first chip includes a return circuit that switches off energization to the controlling target when a value of a current energized to the controlling target exceeds a value set in advance.

15. The vehicle electronic control unit according to claim 1, wherein the circuit board includes a circuit that inputs a signal from the external device to the second chip while bypassing the first chip.

16. The vehicle electronic control unit according to claim 1, wherein the circuit board includes a driving circuit that outputs a signal for driving the controlling target from the second chip while bypassing the first chip.

17. The vehicle electronic control unit according to claim 1, wherein the semiconductor device includes a first custom chip having an input circuit to which a signal from the external device is input formed therein and a second custom chip having an output circuit that outputs a signal to the controlling target formed therein, and the second chip is stacked on the first and second custom chips.
